# EUROPEAN PATENT SPECIFICATION

(11) **EP 1 737 067 B1**
(45) Date of publication and mention of the grant of the patent: **28.12.2016**
(21) Application number: 06010742.2
(22) Date of filing: 24.05.2006
(51) Int. Cl.: H01L 23/66, H01Q 1/22, H01Q 21/28, H01Q 1/44, H01Q 1/40

(54) **Wireless local area network communications module and integrated chip package**
WLAN-Modul und Schaltungschipverpackung
Module WLAN et boitier pour circuit intégré

(30) Priority: 21.06.2005 US 157286
(43) Date of publication of application: 27.12.2006
(73) Proprietor: Marvell World Trade Ltd., St. Michael 14027 (BB)
(72) Inventor: Janofsky, Eric B., Sunnyvale, California 94085 (US)
(74) Representative: Grünecker Patent- und Rechtsanwälte PartG mbB

(56) References cited:
- US-A1- 2002 167 084
- US-A1- 2003 057 545
- US-A1- 2004 008 142
- PATENT ABSTRACTS OF JAPAN vol. 2003, no. 12, 5 December 2003 (2003-12-05) -& JP 2005 064581 A (FUJITSU TEN LTD), 10 March 2005 (2005-03-10)
- SERENI E ET AL: "A Software Radio OFDM Transceiver for WLAN applications" INTERNET CITATION, April 2001 (2001-04), XP002369287 INTERNET

## Description

The present invention relates generally to devices for wireless communications. More particularly, the present invention relates to a wireless local area network communications module and integrated circuit package.

US 2002/167084 A1 discloses a structure of a leadless chip carrier with an embedded antenna. A substrate has a top surface for receiving a semiconductor die. An antenna is patterned on the bottom surface of the substrate. The antenna is accessible by coupling it to a via and, through the via, to a substrate signal bond pad and a semiconductor die signal bond pad. The at least one via provides an electrical connection between a substrate bond pad and the printed circuit board. The via also provides an electrical connection between the signal bond pad of the semi-conductor die and a land that is electrically connected to the printed circuit board.

US 2004/0008142 A1 discloses an integrated circuit for wireless communications that includes substrate, at least one integrated antenna formed in or on the substrate, and a heat sink. At least one dielectric propagating layer is disposed between the integrated antenna and the heat sink.

It is therefore the object of the present invention to provide an improved integrated circuit package for wireless communications that is attachable to a printed circuit board.

This object is solved by the subject matter of the independent claims.

Preferred embodiments are defined by the dependent claims.

In general, in one aspect, the invention features a wireless local area network module comprising: an antenna to receive first orthogonal frequency-division multiplexing (OFDM) signals, and to transmit second OFDM signals; a communication circuit comprising an OFDM demodulator to produce first digital data based on the first OFDM signals, and an OFDM modulator to produce the second OFDM signals based on second digital data; a host interface to provide the first digital data to a host, and to receive the second digital data from the host; an external antenna interface to receive the first OFDM signals from, and to transmit the second OFDM signals to, an external antenna; at least one switch to provide a signal path for the first and second OFDM signals between the communication circuit and one of the antenna and the external antenna interface in accordance with a control signal; and a printed circuit board, wherein the antenna, the communication circuit, and the external antenna interface are arranged on the printed circuit board. Some embodiments comprise an integrated circuit comprising the communication circuit and the external antenna interface.

In general, in one aspect, the invention features a wireless local area network module comprising means for receiving first orthogonal frequency-division multiplexing (OFDM) signals, and for transmitting second OFDM signals; means for communicating comprising OFDM demodulator means for producing first digital data based on the first OFDM signals, and OFDM modulator means for producing the second OFDM signals based on second digital data; host interface means for providing the first digital data to a host, and for receiving the second digital data from, the host; external antenna interface means for receiving the first OFDM signals from, and for transmitting the second OFDM signals to, an external antenna; and at least one switch means for providing a signal path for the first and second OFDM signals between the means for communicating and one of the means for receiving and the external antenna interface means in accordance with a control signal. Some embodiments comprise integrated circuit means comprising the means for communicating and the external antenna interface means.

In general, in one aspect, the invention features an integrated circuit package comprising: at least one integrated circuit comprising a wireless communication circuit comprising an orthogonal frequency-division multiplexing (OFDM) demodulator to produce first digital data based on first OFDM signals, and an OFDM modulator to produce second OFDM signals based on second digital data; an intermediate substrate electrically coupled to the at least one integrated circuit, the intermediate substrate comprising an antenna to receive the first OFDM signals, and to transmit the second OFDM signals, the antenna electrically coupled to the wireless communication circuit; and a package substrate electrically coupled to the intermediate substrate.

Some embodiments comprise a method of forming an integrated circuit package, comprising: providing at least one integrated circuit having a plurality of conductors, the at least one integrated circuit comprising a wireless communication circuit comprising an orthogonal frequency-division multiplexing (OFDM) demodulator to produce first digital data based on first OFDM signals, and an OFDM modulator to produce second OFDM signals based on second digital data; providing an intermediate substrate comprising an antenna to receive the first OFDM signals, and to transmit the second OFDM signals; electrically coupling the antenna to the wireless communication circuit; electrically coupling the conductors on the at least one integrated circuit to the intermediate substrate; and electrically coupling the intermediate substrate to a surface of a package substrate.

In some embodiments, the wireless communication circuit comprises: an orthogonal frequency-division multiplexing (OFDM) demodulator to produce first digital data based on first OFDM signals received by the antenna, and an OFDM modulator to produce second OFDM signals based on second digital data, wherein the second OFDM signals are transmitted by the antenna. In some embodiments, the at least one integrated circuit comprises a first surface and a second surface; wherein the package substrate is electrically coupled via conductive bumps to the first surface of the at least one integrated circuit; and wherein the heat sink is thermally coupled to the second surface of the at least one integrated circuit. In some embodiments, a flip chip ball grid array package comprises the integrated circuit package. In some embodiments, the at least one integrated circuit comprises: a first integrated circuit comprising a media access controller and baseband circuit; and a second integrated circuit comprising a physical-layer device. In some embodiments, the wireless communication circuit comprises: a receive circuit to produce first baseband signals based on first RF signals received by the antenna; and a transmit circuit to produce second RF signals based on second baseband signals, wherein the second RF signals are transmitted by the antenna. In some embodiments, wherein the first baseband signals comprise first digital data; and wherein the second baseband signals comprise second digital data. In some embodiments, wherein the antenna has a length that is a vulgar fraction of a wavelength of the first and second RF signals. In some embodiments, the wireless communication circuit is compliant with at least one standard selected from the group consisting of IEEE standards 802.11, 802.11a, 802.11b, 802.11g, 802.11n, 802.16, and 802.20.

In some embodiments, providing at least one integrated circuit comprises:
providing a first integrated circuit comprising a media access controller and baseband circuit; and providing a second integrated circuit comprising a physical-layer device.

In general, in one aspect, the invention features an integrated circuit package comprising: at least one integrated circuit comprising a wireless communication circuit;-an intermediate substrate electrically coupled to the at least one integrated circuit, the intermediate substrate comprising an antenna electrically coupled to the wireless communication circuit; and a package substrate electrically coupled to the intermediate substrate.

In some embodiments, the wireless communication circuit comprises: an orthogonal frequency-division multiplexing (OFDM) demodulator to produce first digital data based on first OFDM signals received by the antenna, and an OFDM modulator to produce second OFDM signals based on second digital data, wherein the second OFDM signals are transmitted by the antenna. In some embodiments, the intermediate substrate is electrically coupled via conductive bumps to a surface of the at least one integrated circuit; and wherein a surface of the package substrate is electrically coupled to the intermediate substrate by a plurality of bonding wires. In some embodiments, a flip chip ball grid array package comprises the integrated circuit package. In some embodiments, the at least one integrated circuit comprises: a first integrated circuit comprising a media access controller and baseband circuit; and a second integrated circuit comprising a physical-layer device. In some embodiments, the wireless communication circuit comprises: a receive circuit to produce first baseband signals based on first RF signals received by the antenna; and a transmit circuit to produce second RF signals based on second baseband signals, wherein the second RF signals are transmitted by the antenna. In some embodiments, the first baseband signals comprise first digital data; and wherein the second baseband signals comprise second digital data. In some embodiments, the antenna has a length that is a vulgar fraction of a wavelength of the first and second RF signals. In some embodiments, the wireless communication circuit is compliant with at least one standard selected from the group consisting of IEEE standards 802.11, 802.11a, 802.11b, 802.11g, 802.11n, 802.16, and 802.20.

In general, in one aspect, the invention features a method of forming an integrated circuit package, comprising: providing at least one integrated circuit having a plurality of conductors, the at least one integrated circuit comprising a wireless communication circuit; providing an intermediate substrate comprising an antenna; electrically coupling the antenna to the wireless communication circuit; electrically coupling the conductors on the at least one integrated circuit to the intermediate substrate; and electrically coupling the intermediate substrate to a surface of a package substrate.

In some embodiments, providing at least one integrated circuit comprises:
providing a first integrated circuit comprising a media access controller and baseband circuit; and providing a second integrated circuit comprising a physical-layer device.

In some embodiments, the wireless communication circuit comprises: an orthogonal frequency-division multiplexing (OFDM) demodulator to produce first digital data based on first OFDM signals received by the antenna, and an OFDM modulator to produce second OFDM signals based on second digital data, wherein the second OFDM signals are transmitted by the antenna. In some embodiments, the package substrate is electrically coupled via conductive bumps to a surface of the at least one integrated circuit. In some embodiments, a flip chip ball grid array package comprises the integrated circuit package. In some embodiments, the at least one integrated circuit comprises: a first integrated circuit comprising a media access controller and baseband circuit; and a second integrated circuit comprising a physical-layer device. In some embodiments, the wireless communication circuit comprises: a receive circuit to produce first baseband signals based on first RF signals received by the antenna; and a transmit circuit to produce second RF signals based on second baseband signals, wherein the second RF signals are transmitted by the antenna. In some embodiments, the first baseband signals comprise first digital data; and wherein the second baseband signals comprise second digital data. In some embodiments, the antenna has a length that is a vulgar fraction of a wavelength of the first and second RF signals. In some embodiments, the wireless communication circuit is compliant with at least one standard selected from the group consisting of IEEE standards 802.11, 802.11a, 802.11b, 802.11g, 802.11n, 802.16, and 802.20.

In general, in one aspect, the invention features a method of forming an integrated circuit package, comprising: providing at least one integrated circuit having a plurality of conductors, the at least one integrated circuit comprising a wireless communication circuit; electrically coupling the conductors on the at least one integrated circuit to a package substrate comprising an antenna; and electrically coupling the antenna to the wireless communication circuit.

In some embodiments, providing at least one integrated circuit comprises:
providing a first integrated circuit comprising a media access controller and baseband circuit; and providing a second integrated circuit comprising a physical-layer device.

In some embodiments, the wireless communication circuit comprises: an orthogonal frequency-division multiplexing (OFDM) demodulator to produce first digital data based on first OFDM signals received by the antenna, and an OFDM modulator to produce second OFDM signals based on second digital data, wherein the second OFDM signals are transmitted by the antenna. Some embodiments comprise a package substrate electrically coupled via conductive bumps to a surface of the at least one integrated circuit. In some embodiments, a flip chip ball grid array package comprises the integrated circuit package. In some embodiments, the at least one integrated circuit comprises: a first integrated circuit comprising a media access controller and baseband circuit; and a second integrated circuit comprising a physical-layer device. In some embodiments, the wireless communication circuit comprises: a receive circuit to produce first baseband signals based on first RF signals received by the antenna; and a transmit circuit to produce second RF signals based on second baseband signals, wherein the second RF signals are transmitted by the antenna. In some embodiments, the first baseband signals comprise first digital data; and wherein the second baseband signals comprise second digital data. In some embodiments, the antenna has a length that is a vulgar fraction of a wavelength of the first and second RF signals. In some embodiments, the wireless communication circuit is compliant with at least one standard selected from the group consisting of IEEE standards 802.11, 802.11a, 802.11b, 802.11g, 802.11n, 802.16, and 802.20.

In some embodiments, providing at least one integrated circuit comprises:
providing a first integrated circuit comprising a media access controller and baseband circuit; and providing a second integrated circuit comprising a physical-layer device.

The details of one or more implementations are set forth in the accompanying drawings and the description below. Other features will be apparent from the description and drawings, and from the claims.

### DESCRIPTION OF DRAWINGS

FIG 1 shows a WLAN communications module connected to a host such as a personal computer according to a preferred embodiment.
FIG. 2 shows a WLAN communications module comprising an external antenna interface for connecting an external antenna according to a preferred embodiment.
FIG. 3 shows an integrated circuit package comprising a heat sink comprising an antenna.
FIG 4 shows a method of manufacturing an integrated circuit package comprising a heat sink comprising an antenna.
FIG 5 shows an integrated circuit package comprising an intermediate substrate comprising an antenna according to a preferred embodiment.
FIG 6 shows a method of manufacturing an integrated circuit package comprising an intermediate substrate comprising an antenna according to a preferred embodiment.
FIG 7 shows an integrated circuit package comprising a package substrate comprising an antenna
FIG 8 shows a method of manufacturing an integrated circuit package comprising a package substrate comprising an antenna
FIG 9 shows an integrated circuit package comprising a case comprising an antenna.
FIG 10 shows a method of manufacturing an integrated circuit package comprising a case comprising an antenna.

The leading digit(s) of each reference numeral used in this specification indicates the number of the drawing in which the reference numeral first appears.

### DETAILED DESCRIPTION

Embodiments of the present invention comprise a wireless local-area network (WLAN) communications module such as an orthogonal frequency-division multiplexing (OFDM) communications module comprising a host interface. The module can be fabricated, for example, as a PC card for use with a laptop computer. Other embodiments of the module employ other implementations.

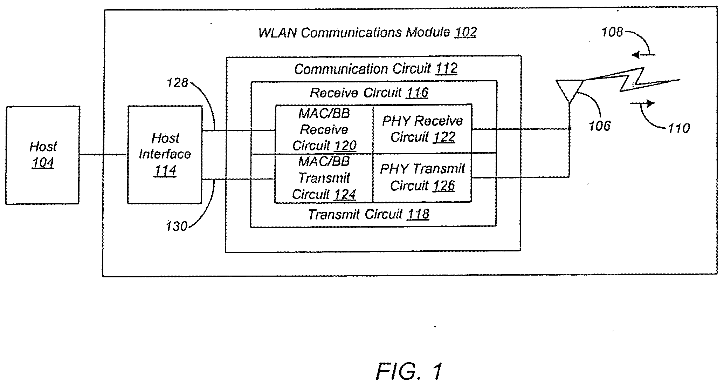

FIG. 1 shows a WLAN communications module 102 connected to a host 104 such as a personal computer according to a preferred embodiment. Module 102 comprises an antenna 106 to receive radio-frequency (RF) signals 108 and to transmit RF signals 110, a communication circuit 112, and a host interface 114 to communicate with host 104, which are preferably arranged on a printed circuit board.

Communication circuit 112 comprises a receive circuit 116 to produce digital data 128 based on RF signals 108, and a transmit circuit 118 to produce RF signals 110 based on digital data 130 received from host 104 over host interface 114. Communication circuit 112 provides digital data 128 to host 104 over host interface 114. Receive circuit 116 preferably comprises a media access controller and baseband (MAC/BB) receive circuit 120 and a physical-layer device (PHY) receive circuit 122 that operate according to well-known techniques. Transmit circuit 118 preferably comprises a MAC/BB transmit circuit 124 and a PHY transmit circuit 126 that operate according to well-known techniques. In some embodiments, module 102 is compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

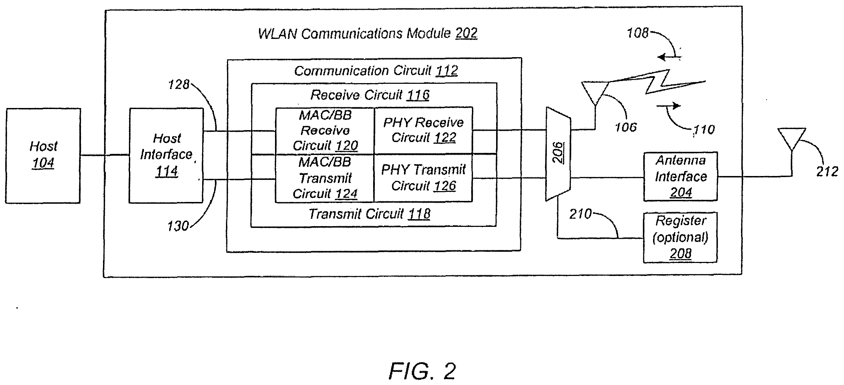

FIG. 2 shows a WLAN communications module 202 comprising an external antenna interface 204 for connecting an external antenna according to a preferred embodiment. Elements 106-130 of module 202 are as described above for communications module 102 of FIG. 1. However, module 202 also includes external antenna interface 204, a switch 206 and an optional memory such as a register 208. External antenna interface 204 can be implemented as a connector that allows an external antenna 212 to be connected to module 202. Switch 206 provides a signal path for RF signals 108, 110 between communication circuit 112 and either antenna 106 or external antenna interface 204 in accordance with a control signal 210. Control signal 210 can be generated in any number of ways. For example, control signal 210 can be provided directly to switch 206 by host 104 over host interface 114, can be stored as a flag in optional register 208, or can be provided by antenna interface 204 on detecting an external antenna 212. In some embodiments, module 202 is compliant with one or more of IEEE standards 802.11, 802.11a, 802.11b, 802.11g, 802.11n, 802.16, and 802.20, other regional and national standards, and the like.

In some embodiments, host interface 114 complies with at least one specification selected from the group comprising complies with at least one specification selected from the group comprising Peripheral Component Interconnect (PCI); PCI Express; Mini PCI; PC card; Universal Serial Bus; and Firewire. Other embodiments employ other specifications for host interface 114.

Embodiments of the present invention comprise an integrated circuit package and method for forming the same, where the integrated circuit package comprises an antenna and at least one integrated circuit preferably implemented in a flip chip ball grid array (FCBGA). In a FCBGA, the integrated circuit is generally connected to a package substrate via solder balls. The package substrate is coupled to the circuit board through solder balls on the underside of the package. Embodiments of the integrated circuit package can be used in embodiments of the communications module to house the communication circuit therein.

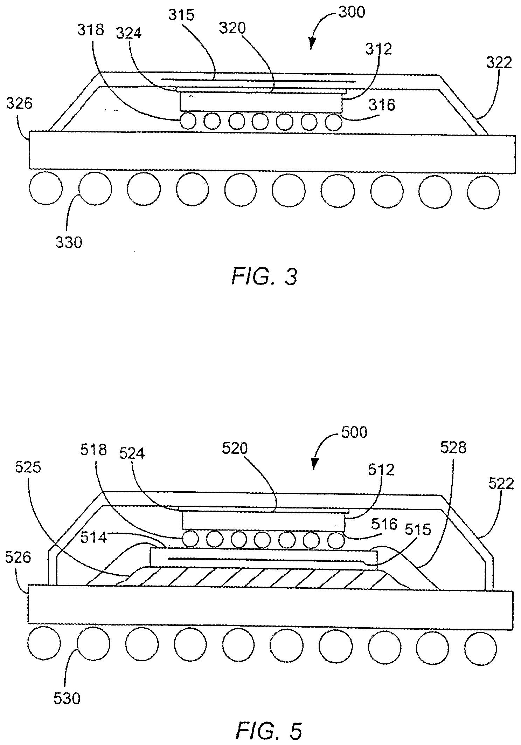

FIG 3 shows an integrated circuit package 300 comprising a heat sink 322 comprising an antenna 315. Integrated circuit
package 300 is preferably a FCBGA that can dissipate heat through heat sink 322. In addition, the thermal path of integrated circuit package 300 extends away from the circuit board to reduce the heat load on the circuit board. But while embodiments of the present invention are described in terms ofFCBGAs, embodiments of the present invention are not limited to FCBGAs, and can be implemented using any other integrated circuit packaging technologies which currently exist or are under development.

Heat sink 322 comprises one or more antennas 315, which can be attached on a surface of heat sink 122 or formed within heat sink 122. In some embodiments, heat sink 315 is an antenna. To accommodate size restrictions imposed by the size of heat sink 322, antenna 315 can have a length that is a vulgar fraction of a wavelength of the signals transmitted and received by antenna 315. A vulgar fraction consists of one integer divided by a non-zero integer, as is well-known in the relevant arts.

Integrated circuit package 300 includes a integrated circuit 312 configured for flip chip mounting. Integrated circuit 312 preferably comprises communications circuits for transmitting and/or receiving data over antenna 315. For example, integrated circuit 312 can comprise a communication circuit comprising a receive circuit to produce first digital data based on first RF signals received by antenna 315, and a transmit circuit to produce second RF signals based on second digital data, wherein the second RF signals are transmitted by antenna 315. The communications circuit can comprise a media access controller/baseband circuit (MAC/BB) and a physical-layer device (PHY) that is electrically connected to antenna 315. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 316 of the integrated circuit 312 is electrically connected to the package substrate 326 via conductive bumps 318. The conductive bumps 318 may be formed from any electrically conductive material such as Pb/Sn solder, Au, Ag, alloys of Au and Ag, and metallic coated polymeric studs. In addition, an epoxy or other suitable material formed between the conductive bumps 318 may be used as an embedding material for the conductive bumps 318 to provide mechanical support and moisture protection. The integrated circuit 312 may be attached to the package substrate 326 using any flip chip compatible bonding method such as thermocompression, soldering, encapsulation, and adhesives.

The other surface 320 of the integrated circuit 312 is attached to a heat sink 322 for coupling heat away from the integrated circuit 312. The heat sink 322 may be made of any thermally conductive material such as copper and thermally conductive plastic. The integrated circuit 312 may be attached to the heat sink 322 by any attachment item 324 that does not thermally isolate the integrated circuit 312 such as adhesive, solder, and press-fitting by applying a mechanical force to the first surface of the integrated circuit 312 or the package substrate 326. For example, a thermally conductive epoxy may be used as the attachment item 324.

Package substrate 326 may be made of any substrate material suitable for ball grid array mounting to a device such as a circuit board or substrate. A plurality of conductive bumps 330 are provided for connecting integrated circuit package 300 to a circuit board or the like.

The number of integrated circuits 312 in integrated circuit package 300 according to embodiments of the present invention is not limited to one. Any practical number of integrated circuits 312 can be implemented within a single integrated circuit package 300 to form a multichip module (MCM). For example, an integrated circuit package 300 can include two integrated circuits 312 where one of the integrated circuits 312 comprises a MAC/BB and the other comprises a PHY.

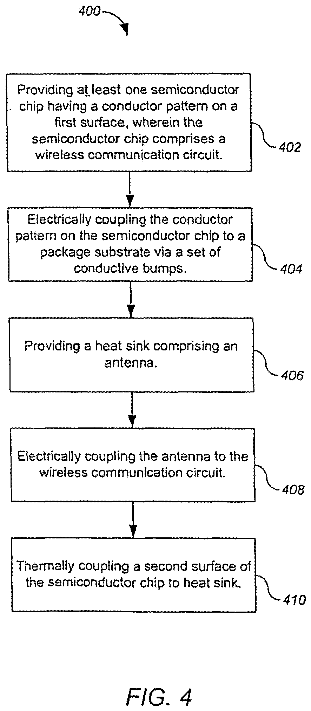

FIG 4 shows a method 400 of manufacturing an integrated circuit package 300 comprising a heat sink 322 comprising an antenna 315. Method 400 comprises providing at least one integrated circuit 312 having a conductor pattern on a first surface, wherein integrated circuit 312 comprises a wireless communication circuit (step 402), electrically coupling the conductor pattern on integrated circuit 312 to a package substrate 326 via a set of conductive bumps 318 (step 404), providing a heat sink 322 comprising an antenna 315 (step 406), electrically coupling antenna 315 to the wireless communication circuit (step 408), and thermally coupling a second surface 320 of integrated circuit 312 to heat sink 322 (step 410).

FIG 5 shows an integrated circuit package 500 comprising an intermediate substrate 514 comprising an antenna 515 according to a preferred embodiment. Integrated circuit package 510 is preferably a modified FCBGA that can optionally dissipate approximately the same amount of beat as a conventional flip chip package at a much lower cost with the addition of optional heat sink 522. In addition, the thermal path of integrated circuit package 500 extends away from the circuit board to reduce the heat load on the circuit board. But while embodiments of the present invention are described in terms of FCBGAs, embodiments of the present invention are not limited to FCBGAs, and can be implemented using any other integrated circuit packaging technologies which currently exist or are under development.

Integrated circuit package 500 includes a integrated circuit 512 configured for flip chip mounting that is attached to an intermediate substrate 514 that comprises one or more antennas 515 that can be formed, for example, by etching intermediate substrate 514. To accommodate size restrictions imposed by the size of intermediate substrate 514, antenna 515 can have a length that is a vulgar fraction of a wavelength of the signals transmitted and received by antenna 515.

Integrated circuit 512 preferably comprises communications circuits for transmitting and/or receiving data over antenna 515. For example, integrated circuit 512 can comprise a communication circuit comprising a receive circuit to produce first digital data based on first RF signals received by antenna 515, and a transmit circuit to produce second RF signals based on second digital data, wherein the second RF signals are transmitted by antenna 515. The communications circuit can comprise a media access controller and baseband (MAC/BB) and a physical-layer device (PHY) that is electrically connected to antenna 515. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 516 of the integrated circuit 512 is electrically connected to the intermediate substrate 514 via conductive bumps 518. The conductive bumps 518 may be formed from any electrically conductive material such as Pb/Sn solder, Au, Ag, alloys of Au and Ag, and metallic coated polymeric studs. In addition, an epoxy or other suitable material formed between the conductive bumps 518 may be used as an embedding material for the conductive bumps 518 to provide mechanical support and moisture protection. The integrated circuit 512 may be attached to the intermediate substrate 514 using any flip chip compatible bonding method such as thermocompression, soldering, encapsulation, and adhesives.

In some embodiments, the other surface 520 of the integrated circuit 512 is attached to an optional heat sink 522 for coupling heat away from the integrated circuit 512. The heat sink 522 may be made of any thermally conductive material such as copper and thermally conductive plastic. The integrated circuit 512 may be attached to the heat sink 522 by any attachment item 524 that does not thermally isolate the integrated circuit 512 such as adhesive, solder, and press-fitting by applying a mechanical force to the first surface of the integrated circuit 512 or the intermediate substrate 514. For example, a thermally conductive epoxy may be used as the attachment item 524.

The intermediate substrate 514 is electrically connected to conductors on a package substrate 526 via several bonding wires 528. The intermediate substrate 514 converts flip chip mounting of the integrated circuit 512 into wire bond mounting to combine and exceed the advantages of FCBGA and PBGA. Similar to FCBGA, the integrated circuit package 500 provides a low resistance thermal path for heat generated in the integrated circuit 512 so that power dissipation may be accommodated. In addition, the thermal path of the integrated circuit package 500 extends to the heat sink 522, away from the package substrate 526, thereby reducing the heat load of the circuit board or circuit substrate to which the integrated circuit package 500 is connected. Also, the integrated circuit package may employ a substrate that is as inexpensive as substrates used for PBGA packages. Additionally, using the intermediate substrate 514 reduces the wiring pitch requirements on bonding wire equipment used for attaching the bonding wires 528.

Package substrate 526 may be made of any substrate material suitable for ball grid array mounting to a device such as a circuit board or substrate. Additionally, a support layer 525 such as an epoxy or other suitable material may be inserted between intermediate substrate 514 and package substrate 526 to provide addition mechanical support. A plurality of conductive bumps 530 are provided for connecting integrated circuit package 500 to a circuit board or the like.

The number of integrated circuits 512 in integrated circuit package 500 according to embodiments of the present invention is not limited to one. Any practical number of integrated circuits 512 can be implemented within a single integrated circuit package 500 to form a multichip module (MCM). For example, an integrated circuit package 500 can include two integrated circuits 512 where one of the integrated circuits 512 comprises a MAC/BB and the other comprises a PHY. Furthermore, while embodiments of the present invention are described in terms of FCBGAs, other embodiments are not limited to FCBGAs, and can be implemented using any other integrated circuit packaging technologies which currently exist or are under development.

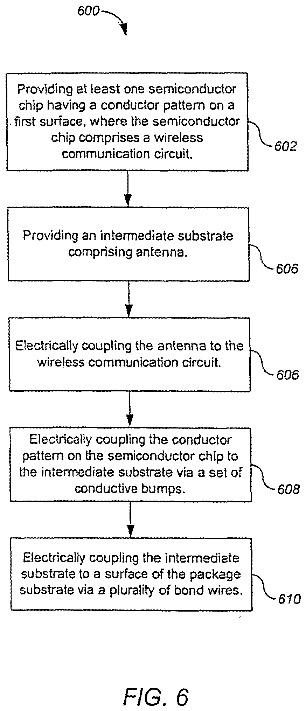

FIG 6 shows a method 600 of manufacturing an integrated circuit package 500 comprising an intermediate substrate 514 comprising an antenna 515 according to a preferred embodiment. Method 600 comprises providing at least one integrated circuit 512 having a conductor pattern on a first surface, wherein integrated circuit 512 comprises a wireless communication circuit (step 602), providing an intermediate substrate 514 comprising an antenna 515 (step 604), electrically coupling antenna 515 to the wireless communication circuit (step 606), electrically coupling the conductor pattern on integrated circuit 512 to intermediate substrate 514 via a set of conductive bumps 518 (step 608), and electrically coupling intermediate substrate 514 to a surface of package substrate 526 via a plurality of bond wires 528 (step 610).

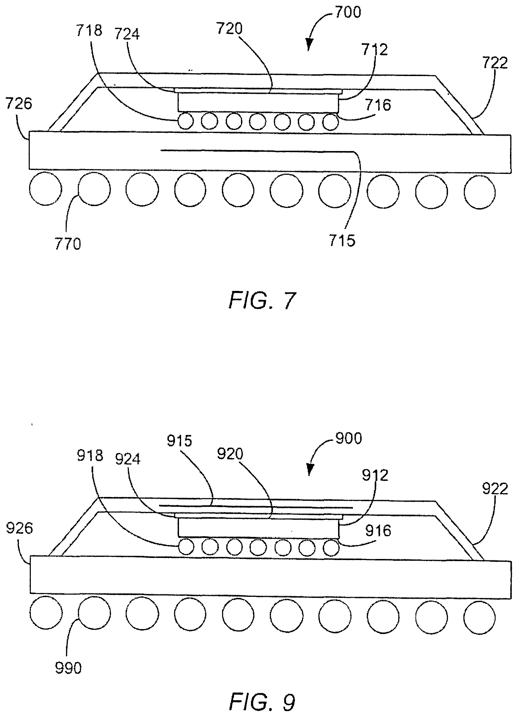

FIG 7 shows an integrated circuit package 700 comprising a package substrate 726 comprising an antenna 715. Integrated circuit package 700 is preferably a FCBGA. But while embodiments of the present invention are described in terms of FCBGAs, embodiments of the present invention are not limited to FCBGAs, and can be implemented using any other integrated circuit packaging technologies which currently exist or are under development.

Package substrate 726 comprises one or more antennas 715, which can be attached on a surface of package substrate 726 or formed within package substrate 726. To accommodate size restrictions imposed by the size of package substrate 726, antenna 715 can have a length that is a vulgar fraction of a wavelength of the signals transmitted and received by antenna 715. A vulgar fraction consists of one integer divided by a non-zero integer, as is well-known in the relevant arts.

Integrated circuit package 700 includes a integrated circuit 712 configured for flip chip mounting. Integrated circuit 712 preferably comprises communications circuits for transmitting and/or receiving data over antenna 715. For example, integrated circuit 712 can comprise a communication circuit comprising a receive circuit to produce first digital data based on first RF signals received by antenna 715, and a transmit circuit to produce second RF signals based on second digital data, wherein the second RF signals are transmitted by antenna 715. The communications circuit can comprise a media access controller/baseband circuit (MAC/BB) and a physical-layer device (PHY) that is electrically connected to antenna 715. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 716 of the integrated circuit 712 is electrically connected to the package substrate 726 via conductive bumps 718. The conductive bumps 718 may be formed from any electrically conductive material such as Pb/Sn solder, Au, Ag, alloys of Au and Ag, and metallic coated polymeric studs. In addition, an epoxy or other suitable material formed between the conductive bumps 718 may be used as an embedding material for the conductive bumps 718 to provide mechanical support and moisture protection. The integrated circuit 712 may be attached to the package substrate 726 using any flip chip compatible bonding method such as thermocompression, soldering, encapsulation, and adhesives.

The other surface 720 of the integrated circuit 712 is optionally attached to a heat sink 722 for coupling heat away from the integrated circuit 712. Optional heat sink 722 may be made of any thermally conductive material such as copper and thermally conductive plastic. The integrated circuit 712 may be attached to the heat sink 722 by any attachment item 724 that does not thermally isolate the integrated circuit 712 such as adhesive, solder, and press-fitting by applying a mechanical force to the first surface of the integrated circuit 712 or the package substrate 726. For example, a thermally conductive epoxy may be used as the attachment item 724.

Package substrate 726 may be made of any substrate material suitable for ball grid array mounting to a device such as a circuit board or substrate. A plurality of conductive bumps 730 are provided for connecting integrated circuit package 700 to a circuit board or the like.

The number of integrated circuits 712 in integrated circuit package 700 according to embodiments of the present invention is not limited to one. Any practical number of integrated circuits 712 can be implemented within a single integrated circuit package 700 to form a multichip module (MCM). For example, an integrated circuit package 700 can include two integrated circuits 712 where one of the integrated circuits 712 comprises a MAC/BB and the other comprises a PHY.

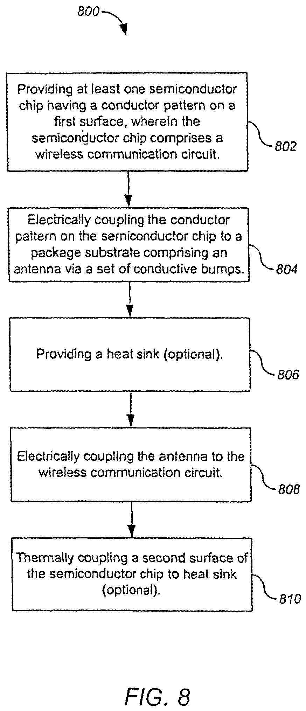

FIG 8 shows a method 800 of manufacturing an integrated circuit package 700 comprising a package substrate 726 comprising an antenna 715. Method 800 comprises providing at least one integrated circuit 712 having a conductor pattern on a first surface, wherein integrated circuit 712 comprises a wireless communication circuit (step 802), electrically coupling the conductor pattern on integrated circuit 712 to a package substrate 726 comprising an antenna 715 via a set of conductive bumps 718 (step 804), providing optional heat sink 722 (step 806), electrically coupling antenna 715 to the wireless communication circuit (step 808), and optionally thermally coupling a second surface 720 of integrated circuit 712 to optional heat sink 722 (step 810).

FIG 9 shows an integrated circuit package 900 comprising a case 922 comprising an antenna 915. Case 922 can be made of plastic, ceramic, or any other material, as is well-known in the relevant arts. Integrated circuit package 900 is preferably a FCBGA. But while embodiments of the present invention are described in terms of FCBGAs, embodiments of the present invention are not limited to FCBGAs, and can be implemented using any other integrated circuit packaging technologies which currently exist or are under development.

Case 922 comprises one or more antennas 915, which can be attached on a surface of case 122 or formed within case 122. To accommodate size restrictions imposed by the size of case 922, antenna 915 can have a length that is a vulgar fraction of a wavelength of the signals transmitted and received by antenna 915. A vulgar fraction consists of one integer divided by a non-zero integer, as is well-known in the relevant arts.

Integrated circuit package 900 includes a integrated circuit 912 configured for flip chip mounting. Integrated circuit 912 preferably comprises communications circuits for transmitting and/or receiving data over antenna 915. For example, integrated circuit 912 can comprise a communication circuit comprising a receive circuit to produce first digital data based on first RF signals received by antenna 915, and a transmit circuit to produce second RF signals based on second digital data, wherein the second RF signals are transmitted by antenna 915. The communications circuit can comprise a media access controller/baseband circuit (MAC/BB) and a physical-layer device (PHY) that is electrically connected to antenna 915. The communication circuit is preferably compliant with one or more of IEEE standards 802.11, 802.11a, 802.11b, 802.11g, 802.11n, 802.16, and 802.20, other regional and national standards, and the like. In some embodiments, the communication circuit comprises an OFDM demodulator and an OFDM modulator for use in a wireless LAN.

A first surface 916 of the integrated circuit 912 is electrically connected to the package substrate 926 via conductive bumps 918. The conductive bumps 918 may be formed from any electrically conductive material such as Pb/Sn solder, Au, Ag, alloys of Au and Ag, and metallic coated polymeric studs. In addition, an epoxy or other suitable material formed between the conductive bumps 918 may be used as an embedding material for the conductive bumps 918 to provide mechanical support and moisture protection. The integrated circuit 912 may be attached to the package substrate 926 using any flip chip compatible bonding method such as thermocompression, soldering, encapsulation, and adhesives. Antenna 915 can be electrically coupled to integrated circuit 912 by conductive bumps 918, by other conventional types of interconnects, or by a special-purpose interconnect provided especially for antenna 915.

Package substrate 926 may be made of any substrate material suitable for ball grid array mounting to a device such as a circuit board or substrate. A plurality of conductive bumps 930 are provided for connecting integrated circuit package 900 to a circuit board or the like.

The number of integrated circuits 912 in integrated circuit package 900 according to embodiments of the present invention is not limited to one. Any practical number of integrated circuits 912 can be implemented within a single integrated circuit package 900 to form a multichip module (MCM). For example, an integrated circuit package 900 can include two integrated circuits 912 where one of the integrated circuits 912 comprises a MAC/BB and the other comprises a PHY.

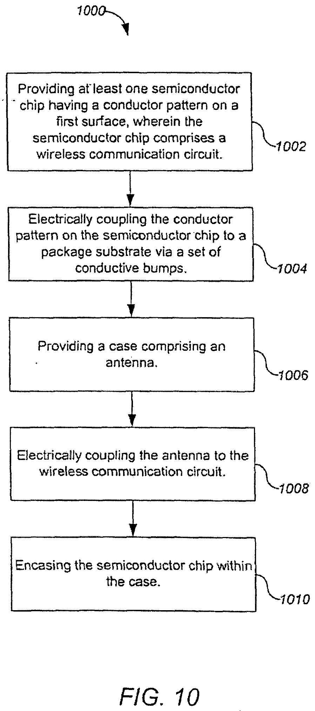

FIG 10 shows a method 1000 of manufacturing an integrated circuit package 900 comprising a case 922 comprising an antenna 915. Method 1000 comprises providing at least one integrated circuit 912 having a conductor pattern on a first surface, wherein integrated circuit 912 comprises a wireless communication circuit (step 1002), electrically coupling the conductor pattern on integrated circuit 912 to a package substrate 926 via a set of conductive bumps 918 (step 1004), providing a case 922 comprising an antenna 915 (step 1006), electrically coupling antenna 915 to the wireless communication circuit (step 1008), and encasing integrated circuit 912 within case 922 (step 1010).

## Claims

1. An integrated circuit package (500) comprising:
at least one integrated circuit (512) configured for flip-chip mounting and comprising a wireless communication circuit
comprising
an orthogonal frequency-division multiplexing, OFDM, demodulator to produce first digital data based on first OFDM signals, and
an OFDM modulator to produce second OFDM signals based on second digital data; an intermediate substrate (514) electrically coupled to the at least one integrated circuit via conductive bumps (518), the intermediate substrate comprising an antenna (515) to receive the first OFDM signals, and to transmit the second OFDM signals, the antenna electrically coupled to the wireless communication circuit; and
a package substrate (526) configured for ball grid array mounting and electrically coupled to the intermediate substrate, wherein
the intermediate substrate is arranged between the at least one integrated circuit and the package substrate.

2. The integrated circuit package of claim 1:
wherein the intermediate substrate is electrically coupled via conductive bumps (518) to a surface (516) of the at least one integrated circuit; and
wherein a surface of the package substrate is electrically coupled to the intermediate substrate by a plurality of bonding wires (528).

3. The integrated circuit package (500) of claim 1, wherein the at least one integrated circuit (512) comprises:
a first integrated circuit comprising a media access controller and baseband circuit; and
a second integrated circuit comprising a physical-layer device.

4. The integrated circuit package (500) of claim 1, wherein the wireless communication circuit comprises:
a receive circuit to produce first baseband signals based on first RF signals received by the antenna (515); and
a transmit circuit to produce second RF signals based on second baseband signals,
wherein the second RF signals are transmitted by the antenna.

5. The integrated circuit package (500) of claim 4:
wherein the first baseband signals comprise first digital data; and
wherein the second baseband signals comprise second digital data.

6. The integrated circuit package (500) of claim 4 or 5:
wherein the antenna (515) has a length that is a vulgar fraction of a wavelength of the first and second RF signals.

7. The integrated circuit package (500) of one of claims 1 to 6, wherein the wireless communication circuit is compliant with at least one standard selected from the group consisting of IEEE standards 802.11, 802.11a, 802.11 b, 802.11g, 802.11n, 802.16, and 802.20.

8. A flip chip ball grid array package comprising the integrated circuit package (500) of one of claims 1 to 7.

## Patentansprüche

1. Integrierte Schaltkreispackung (500), umfassend:
wenigstens einen integrierten Schaltkreis (512), der für eine Flip-Chip-Anbringung eingerichtet ist und einen Drahtloskommunikationsschaltkreis enthält, umfassend
einen OFDM-Demodulator (OFDM - Orthogonales Frequenzmultiplexen), um erste Digitaldaten auf der Basis erster OFDM-Signale zu erzeugen, und
einen OFDM-Modulator, um zweite OFDM-Signale auf der Basis zweiter Digitaldaten zu erzeugen;
ein Zwischensubstrat (514), das mit dem wenigstens einen integrierten Schaltkreis über leitfähige Erhebungen (518) elektrisch verbunden ist, wobei das Zwischensubstrat eine Antenne (515) umfasst, um die erste OFDM-Signale zu erfassen und die zweiten OFDM-Signale zu senden, und die Antenne mit dem drahtlosen Kommunikationsschaltkreis elektrisch verbunden ist; und
ein Packungssubstrat (526), das für eine Ball-Grid-Array-Anbringung eingerichtet und mit dem Zwischensubstrat elektrisch verbunden ist, wobei
das Zwischensubstrat zwischen dem wenigstens einen integrierten Schaltkreis und dem Packungssubstrat angeordnet ist.

2. Integrierte Schaltkreispackung nach Anspruch 1:
bei der das Zwischensubstrat über elektrische Erhebungen (518) mit einer Oberfläche (516) des wenigstens einen integrierten Schaltkreises elektrisch verbunden ist; und
eine Oberfläche des Packungssubstrates mit dem Zwischensubstrat durch eine Vielzahl von Verbindungsdrähten (528) elektrisch verbunden ist.

3. Integrierte Schaltkreispackung (500) nach Anspruch 1, bei der der wenigstens eine integrierte Schaltkreis (512) umfasst:
einen ersten Integrierten Schaltkreis, der eine Medienzugriffssteuereinheit und einen Basisbandschaltkreis umfasst; und
einen zweiten integrierten Schaltkreis, der eine Vorrichtung einer physikalischen Schicht umfasst.

4. Integrierte Schaltkreispackung (500) nach Anspruch 1, bei der der drahtlose Kommunikationsschaltkreis umfasst:
einen Empfangsschaltkreis, um erste Basisbandsignale auf der Basis erster HF-Signale zu erzeugen, die von der Antenne (515) empfangen werden; und
einen Sendeschaltkreis, um zweite HF-Signale auf der Basis zweiter Basisbandsignale zu erzeugen, wobei die zweiten HF-Signale durch die Antenne gesendet werden.

5. Integrierte Schaltkreispackung (500) nach Anspruch 4:
bei der die ersten Basisbandsignale erste Digitalsignale umfassen; und
die zweiten Basisbandsignale zweite Digitalsignale umfassen.

6. Integrierte Schaltkreispackung (500) nach Anspruch 4 oder 5:
bei der die Antenne (515) eine Länge hat, die ein gemeiner Bruch einer Wellenlänge des ersten und des zweiten HF-Signals ist.

7. Integrierte Schaltkreispackung (500) nach einem der Ansprüche 1 bis 6, bei der der drahtlose Kommunikationsschaltkreis wenigstens einen Standard wählt, der aus der Gruppe gewählt ist, die aus den IEEE-Standards 802.11, 802.11a, 802.11 b, 802.11 g, 802.11n, 802.16 und 802.20 besteht.

8. Flip-Chip-Ball-Anordnungspacket, umfassend das integrierte Schaltkreispaket (500) nach einem der Ansprüche 1 bis 7.

## Revendications

1. Boîtier de circuit intégré (500) comprenant :
au moins un circuit intégré (512) conçu pour le montage de puces retournées et comprenant un circuit de communication sans fil,
comprenant
un démodulateur OFDM (*orthogonal frequency-division multiplexing*) pour produire des premières données numériques sur la base de premiers signaux OFDM, et
un modulateur OFDM pour produire des seconds signaux OFDM sur la base de secondes données numériques ;
un substrat intermédiaire (514) couplé électriquement au au moins un circuit intégré via des bosses conductrices (518), le substrat intermédiaire comprenant une antenne (515) pour recevoir les premiers signaux OFDM et pour transmettre les seconds signaux OFDM, l'antenne étant couplée électriquement au circuit de communication sans fil ; et
un substrat de boîtier (526) conçu pour un montage de matrice à bille et électriquement couplé au substrat intermédiaire, où
le substrat intermédiaire est agencé entre l'au moins un circuit intégré et le substrat de boîtier.

2. Boîtier de circuit intégré selon la revendication 1 :
où le substrat intermédiaire est couplé électriquement avec une surface (516) du au moins un circuit intégré via des bosses conductrices (518) ; et
où une surface du substrat de boîtier est couplée électriquement avec le substrat intermédiaire par une pluralité de fils de connexion (528).

3. Boîtier de circuit intégré (500) selon la revendication 1, où l'au moins un circuit intégré (512) comprend :
un premier circuit intégré comprenant un contrôleur d'accès au support et un circuit en bande de base ;
et
un second circuit intégré comprenant un dispositif de couche physique.

4. Boîtier de circuit intégré (500) selon la revendication 1, où le circuit de communication sans fil comprend :
un circuit de réception pour produire des premiers signaux en bande de base sur la base de premiers signaux RF reçus par l'antenne (515) ; et
un circuit de transmission pour produire des seconds signaux RF sur la base de seconds signaux en bande de base, où les seconds signaux RF sont transmis par l'antenne.

5. Boîtier de circuit intégré (500) selon la revendication 4 :
où les premiers signaux en bande de base comprennent des premières données numériques ; et
où les seconds signaux en bande de base comprennent des secondes données numériques.

6. Boîtier de circuit intégré (500) selon la revendication 4 ou 5 :
où l'antenne (515) a une longueur égale à une fraction commune d'une longueur d'ondes des premiers et seconds signaux RF.

7. Boîtier de circuit intégré (500) selon l'une des revendications 1 à 6, où le circuit de communication sans fil remplit au moins une norme choisie dans le groupe comprenant les normes IEEE 802.11, 802.11 a, 802.11 b, 802.11 g, 802.11 n, 802.16 et 802.20.

8. Boîtier de matrice à bille de puce retournée comprenant le boîtier de circuit intégré (500) selon l'une des revendications 1 à 7.
